# EUROPÄISCHE PATENTSCHRIFT

(11) **EP 2 959 584 B1**
(45) Veröffentlichungstag und Bekanntmachung des Hinweises auf die Patenterteilung: **10.05.2017**
(21) Anmeldenummer: 14705168.4
(22) Anmeldetag: 18.02.2014
(51) Int. Cl.: H03K 17/691

(54) **LEISTUNGSELEKTRONISCHE SCHALTUNG UND SYSTEM MIT DERSELBEN**
POWER-ELECTRONIC CIRCUIT AND SYSTEM HAVING SAME
CIRCUIT ÉLECTRONIQUE DE PUISSANCE ET SYSTÈME LE COMPRENANT

(30) Priorität: 28.03.2013 DE 102013205706
(43) Veröffentlichungstag der Anmeldung: 30.12.2015
(73) Patentinhaber: Fraunhofer-Gesellschaft zur Förderung der angewandten Forschung e.V., 80686 München (DE); Friedrich-Alexander-Universität Erlangen-Nürnberg, 91054 Erlangen (DE)
(72) Erfinder: ZELTNER, Stefan, 91058 Erlangen (DE); ENDRES, Stefan, 91074 Herzogenaurach (DE)
(74) Vertreter: Zimmermann, Tankred Klaus
(86) Internationale Anmeldenummer: PCT/EP2014/053119
(87) Internationale Veröffentlichungsnummer: WO 2014/154397

(56) Entgegenhaltungen:
- EP-A1- 1 768 257
- EP-A1- 2 302 798
- US-A- 5 384 808
- US-A- 5 900 683
- US-A1- 2009 212 759
- US-A1- 2012 212 075
- ANNA MAYER ET AL: "Control Concept of the Modular High Frequency Converter for Vehicle Applications", PCIM,, Bd. Paper 92, 17. Mai 2011 (2011-05-17), Seiten 556-561, XP009159034, ISBN: 978-1-61839-061-5

## Beschreibung

Die vorliegende Erfindung bezieht sich auf das Gebiet der Leistungselektronik, und hier insbesondere auf eine Schaltung mit einem aktiven Element, einer Treiberschaltung, einer Ansteuerlogik und einer Schnittstellenschaltung, sowie auf ein System umfassend eine oder mehrere solche Schaltungen.

Moderne leistungselektronische Systeme beinhalten oftmals eine Vielzahl aktiv anzusteuernder leistungselektronischer Elemente, beispielsweise Schalter in Form von IGBTs oder MOSFETs. Beispiele für solche leistungselektronischen Systeme finden sich in On-Board-Ladegeräten für Elektrofahrzeuge, in Multiport-DC/DC-Wandlern für komplexe Energiemanagementaufgaben oder auch in Umrichtern zur drehzahlgeregelten Steuerung elektrischer Maschinen. Die Realisierung solcher leistungselektronischer Systeme erfolgt oftmals durch eine Unterteilung des Systems in Teil- oder Subsysteme, z.B. in eine aktive Frontend-Schaltung und eine galvanisch getrennte Wandlerstufe im Falle eines On-Board-Ladegeräts, in mehrere bidirektionale Hoch-Tiefsetzsteller im Falle von Multiport-DC/DC-Wandlern oder in mehrere Halbbrücken-Schaltungen bei Motor-Umrichtern. Weitere leistungselektronische Systeme mit einer Mehrzahl von aktiv anzusteuernden leistungselektronischen Elementen umfassen beispielsweise Wechselrichter zur Umwandlung von Gleichstrom, der durch Solaranlagen erzeugt wird, in einen Wechselstrom zur Einspeisung in ein Wechselstromnetz.

Im Falle leistungselektronischer Schalter ist zur Ansteuerung Energie, beispielsweise in Form eines Hilfsenergiesignals zur Versorgung der Ansteuerschaltung, und das eigentliche Schalteransteuersignal notwendig, beispielsweise ein Gate-Ansteuersignal im Falle einer Realisierung des Schalters unter Verwendung von z.B. IGBTs oder Feldeffekttransistoren. Hierbei ist es erforderlich, ggf. eine große Vielzahl von aktiven Leistungsschaltern bzw. aktiven Leistungselementen störsicher anzusteuern und gleichzeitig den Aufwand zu minimieren. Ferner kann eine galvanische Isolation zwischen der übergeordneten, dem Anwender zugewandten Steuereinheit und der eigentlichen leistungselektronischen Einheit, z.B. dem Leistungsmodul, vorgesehen bzw. vorgeschrieben sein.

Galvanisch isolierte Treiber- bzw. Ansteuerschaltungen sind im Stand der Technik bekannt. Der Aufwand für eine galvanisch isolierte Ansteuerung mehrerer Leistungsschalter ist erheblich. Bekannte Ansätze verwenden daher auch sogenannte intelligente Leistungsmodule (IPM = Intelligent Power Module), die beispielsweise zur Realisierung vollständiger Teileinheiten konzipiert sind, z.B. in Form eines Motorumrichters inklusive eines Brems-Choppers. Diese Ansätze zeichnen sich dadurch aus, dass ein typisches Leistungsmodul durch die Integration weiterer Funktionalitäten, z.B. durch die Integration der Treiber- bzw. Ansteuerschaltung, erweitert wird, wobei das gemeinsame Merkmale aller intelligenten Leistungsmodule darin zu sehen ist, dass eine übergeordnete Steuereinheit mit der erforderlichen Ansteuerlogik erforderlich ist, um beispielsweise entsprechende Gate-Ansteuersignale dem IPM zur Verfügung zu stellen.

Im Stand der Technik sind weiterhin Ansätze bekannt, die darauf abzielen, den hohen Schnittstellen-bzw. Interface-Aufwand zur Ansteuerung der einzelnen leistungselektronischen Schalter, z.B. des IPMs, bzw. die notwendigen Schaltungen zur Bereitstellung der notwendigen Hilfsversorgungen zu reduzieren. Beispielhaft sei auf die Dissertation von S. Zeltner "Untersuchungen zu isolierenden verlustarmen kompakten Ansteuerschaltungen mit integrierter Regelung des Laststroms", Uni Erlangen 2011, verwiesen. Das dort beschriebene Konzept erweitert die Funktionalität einer Ansteuerschaltung um Reglereinheiten und Einheiten zur Erzeugung der Gate-Ansteuersignale, so dass diese Treiber- bzw. Ansteuerschaltung die Funktionalität einer gesteuerten Stromquelle erfüllt. Hierdurch lässt sich der Schnittstellenaufwand reduzieren, da es nur noch erforderlich ist, die Hilfsversorgungsspannungen sowie die Trigger- und Sohwertvorgaben an das IPM zu übergeben. Bei diesem Konzept liegen die Einheiten zur Erweiterung der Funktionalität, der Regler und die PWM-Einheit, auf der Primärseite der Ansteuerschaltung (d.h. diese sind direkt mit der übergeordneten Steuereinheit verbunden), was aber weitere Maßnahmen im Hinblick auf die Übertragung der Signale erfordert. So sind z.B. für eine störsichere Übertragung eines Synchronisationssignals und für eine Übertragung einer Sollwertvorgabe beispielsweise eine digitale Übertragung oder die Verwendung von Differenzsignalübertragungen bzw. weitere galvanische Trennungen erforderlich. Hierdurch ergibt sich ein erheblicher Interface-Aufwand. Zudem ist nachteilhaft, dass die Energieübertragung getrennt von der Gate-Signalübertragung erfolgt, so dass sich die Gesamtkoppelkapazität zwischen der übergeordneten Steuereinheit und der der Leistungselektronik zugewandten Sekundärseite erhöht.

Im Stand der Technik sind ferner Ansätze bekannt, den Aufwand im Zusammenhang mit der notwendigen galvanischen Trennung und der Gate-Signalübertragung dadurch zu minimieren, dass das Gate-Ansteuersignal sowie die erforderliche Hilfsenergie über einen gemeinsamen Transformator übertragen wird, wie dies beispielsweise von S. Y. Hui et al. in "Coreless Printed Circuit Board (PCB) Transformers for Power MOSFET/IGBT Gate Drive Circuits", IEEE Transactions On Power Electronics, Vol. 14, Nr. 3, Mai 1999 oder von S. Zeltner et al., "A Compact IGBT Driver for High Temperature Applications", PCIM Europe 2003, Nürnberg 2003, Deutschland, beschrieben wird. Hierdurch wird eine Reduzierung der Gesamtkoppelkapazität zwischen der Primärseite und der Sekundärseite herbeigeführt, jedoch ist nachteilig, dass stets Kompromisse bezüglich der zu übertragenden Leistung auf der einen Seite und der erzielbaren Übertragungseigenschaften des Gate-Ansteuersignals auf der anderen Seite vorliegen. Beispielsweise kann das Gate-Ansteuersignal mit einer unerwünschten Verzögerung (Delay) oder einem unerwünschten Jitter beaufschlagt sein, so dass eine genaue und ordnungsgemäße Steuerung nicht möglich ist, insbesondere nicht bei zunehmenden Schaltfrequenzen in leistungselektronischen Systemen, wie sie beispielsweise bei Einsatz moderner leistungselektronischer Schaltungen in SiC- oder GaN-Technologie angetroffen werden. Dort tritt dieses Problem immer stärker zu Tage und ist immer weniger lösbar.

Im Stand der Technik ist ferner ein Ansatz gemäß dem US-Patent US 5,900,683 von Ford bekannt, welches einen isolierten Gate-Treiber für Leistungsschaltelemente offenbart, wobei vorgesehen ist, einen Gate-Treiber unter Verwendung eines ersten Lastsignals, das bei einer ersten Frequenz moduliert ist, und unter Verwendung eines zweiten Lastsignals, welches bei einer zweiten Frequenz moduliert ist, zu steuern, wobei die zwei Frequenzen voneinander unterschiedlich sind und so gewählt sind, dass das erste Lastsignal ein Einschalten des Transistors bewirkt, und das zweite Lastsignal ein Ausschalten des Transistors bewirkt. Der Nachteil dieser Vorgehensweise ist ähnlich den Nachteilen, die oben im Zusammenhang mit den Ansätzen von Hui et al. und S. Zeltner et al. beschrieben wurden, nämlich, dass eine Übertragung der Ansteuersignale von externen Quellen (typischerweise einer zentralen Steuereinheit) über eine Isolationsbarriere an die Schalter erfolgt, so dass die oben beschriebenen Probleme im Hinblick mit Beeinträchtigungen der Signale während der Übertragung, insbesondere bei zunehmenden Schaltfrequenzen, vorliegen.

Wiederum ein weiterer Ansatz ist in der US 2012/0212075 A1 von Arnet beschrieben, bei der eine programmierbare Gate-Controllerschaltung vorgesehen ist, die zumindest einen programmierbaren Gate-Controller umfasst, der über eine bidirektionale Verbindung mit einem zentralen Controller und mit zumindest einem Leistungsschalter verbunden ist. Die Steuersignale werden in dem programmierbaren Gate-Controller erzeugt und an den Schalter bereitgestellt, wobei der Gate-Controller durch Steuersignale von dem zentralen Controller programmiert wird. Die bidirektionale Kommunikation erfolgt über einen bidirektionalen Bus, wobei eine Isolation zwischen dem zentralen Controller und dem programmierbaren Gate-Controller vorgesehen ist. Nachteilig an dieser Vorgehensweise ist, dass die erforderlichen Hilfsenergiesignale von zusätzlichen externen Quellen bereitgestellt werden, so dass weitere, galvanisch entkoppelte Schnittstellen für die Hilfsenergieversorgungen (z.B. für Gatetreiber, Logikeinheiten, Messschaltungen) vorgesehen sind.

Ausgehend von diesem Stand der Technik liegt der vorliegenden Erfindung die Aufgabe zugrunde, eine verbesserte Schaltung zu schaffen, bei der der Aufwand für die Schnittstelle zum Empfang externer Daten- und Hilfsenergiesignale reduziert werden kann, bei gleichzeitiger Verbesserung der galvanischen Trennung der Schaltung von externen Elementen (Minimierung der Koppelkapazität).

Diese Aufgabe wird erfindungsgemäß durch eine Schaltung gemäß Anspruch 1 und durch ein System gemäß Anspruch 15 gelöst.

Gemäß Ausführungsbeispielen kann das Primärsignal ein gleichanteilfreies Rechtecksignal mit
im Wesentlichen konstanter Frequenz umfassen. Das Primärsignal kann z.B. ein Manchester-codiertes Signal umfassen.
Gemäß Ausführungsbeispielen umfasst das Primärsignal einen seriellen Bitstrom.

Gemäß Ausführungsbeispielen umfasst die Schaltung einen Decodierer, der ausgebildet ist, um das empfangene Primärsignal zu decodieren, um Daten zur Einstellung und/oder Programmierung der Ansteuerlogik zu erhalten. Die Ansteuerlogik kann den Decodierer umfassen.

Gemäß Ausführungsbeispielen umfasst die Schnittstellenschaltung einen Transformator, an dessen Primärseite das Primärsignal anliegt, und an dessen Sekundärseite das Datensignal für die Ansteuerlogik und das Hilfsenergiesignal für die Treiberschaltung gewonnen werden, z.B. über eine Gleichrichterschaltung, die mit der Sekundärseite des Transformators verbunden ist.

Gemäß Ausführungsbeispielen ist die Schnittstellenschaltung ausgebildet, um basierend auf dem empfangenen Primärsignal ein weiteres Hilfsenergiesignal für die Ansteuerlogik an dem sekundären Anschluss bereitzustellen.

Gemäß Ausführungsbeispielen sind das aktive Element und die Ansteuerlogik zusätzlich galvanisch getrennt oder über eine geeignete Pegelanpassungsschaltung verbunden (Levelshifter), wobei die Treiberschaltung das Element zur galvanischen Trennung des aktiven Elements und der Ansteuerlogik bzw. die Pegelanpassungsschaltung umfassen kann.

Gemäß Ausführungsbeispielen umfasst die Schaltung einen ersten Leistungsanschluss und einen zweiten Leistungsanschluss, wobei das aktive Element zwischen den ersten und zweiten Leistungsanschluss geschaltet ist. Die Ansteuerlogik kann mit dem ersten und zweiten Leistungsanschluss zum Erfassen eines Messsignals verbunden sein.

Gemäß Ausführungsbeispielen umfasst die Schaltung eine Kombination mehrerer aktiver und passiver Leistungsbauelemente wodurch sich mehrere Leistungsanschlüsse und/oder innere Knoten ergeben, wobei die Ansteuerlogik alternativ oder zusätzlich mit den weiteren Leistungsanschlüssen bzw. inneren Knoten zum Erfassen eines oder mehrerer Messsignale verbunden ist.

Gemäß Ausführungsbeispielen umfasst die Schaltung eine Messschaltung, die mit der Ansteuerlogik zum Bereitstellen eines Messsignals an dieselbe verbunden ist, wobei die Schnittstellenschaltung ausgebildet ist, um basierend auf dem empfangenen Primärsignal ein Hilfsenergiesignal für die Messschaltung an dem sekundären Anschluss bereitzustellen.

Gemäß Ausführungsbeispielen umfasst die Schaltung zumindest ein weiteres aktives Element, dem eine weitere Treiberschaltung zugeordnet ist, wobei die Schnittstellenschaltung ausgebildet ist, um basierend auf dem empfangenen Primärsignal ein Hilfsenergiesignal für die weitere Treiberschaltung bereitzustellen. Ferner kann eine weitere Ansteuerlogik zum Bereitstellen eines weiteren Ansteuersignals für die weitere Treiberschaltung vorgesehen sein.

Gemäß Ausführungsbeispielen umfasst das aktive Element einen oder mehrere leistungselektronische Schalter, z.B. IGBTs, FETs, Bipolartransistoren oder andere, deren Steueranschlüsse mit einer oder mehreren der Treiberschaltungen verbunden sind.

Gemäß Ausführungsbeispielen ist die Ansteuerlogik wirksam, um ansprechend auf die durch das Primärsignal übertragenen Daten eine vorbestimmte Ansteuerung der Treiberschaltung für das aktive Element zu bewirken und/oder vorbestimmte Messungen und/oder Steuerungen bzw. Regelungen durchzuführen.

Gemäß Ausführungsbeispielen ist die Schnittstellenschaltung ferner ausgebildet, um eine Ausgabe eines Signal auf der Primärseite zu bewirken.

Gemäß Ausführungsbeispielen umfasst das Primärsignal Korrektur- und/oder Prüfinformationen für eine fehlertolerante Übertragung.

Die vorliegende Erfindung schafft ferner ein System, mit einer zentralen Steuereinheit und einer erfindungsgemäßen Schaltung.

Gemäß Ausführungsbeispielen umfasst das System einen Bus zum Übertragen des durch die zentrale Steuerungseinheit erzeugten Primärsignals an die Schaltung, wobei der Bus eine Zwei-Draht-Verbindung zwischen der zentralen Steuereinheit und der Schaltung umfassen kann, wobei der primäre Anschluss der Schnittstellenschaltung einen ersten Anschluss, der mit einem Draht der Zwei-Draht-Verbindung verbunden ist, und einen zweiten Anschluss umfasst, der mit dem anderen Draht der Zwei-Draht-Verbindung verbunden ist.

Gemäß Ausführungsbeispielen umfasst das System zumindest eine weitere erfindungsgemäße Schaltung, wobei die zumindest eine weitere Schaltung über eine weitere Zwei-Draht-Verbindung mit der zentralen Steuereinheit, oder mit dem primären Anschluss der Schaltung, oder mit der Zwei-Draht-Verbindung zwischen der zentralen Steuereinheit und der Schaltung verbunden sein kann.

Gemäß Ausführungsbeispielen wird somit ein Ansatz geschaffen, der die oben erwähnten Probleme im Zusammenhang mit bekannten leistungselektronischen Schaltungen verhindert, und eine sichere und zuverlässige Ansteuerung der aktiven Elemente einer solchen Schaltung auch bei höheren Schaltfrequenzen ermöglicht, indem die Ansteuerelektronik zusammen mit den aktiven Elementen vorgesehen ist, so dass die erforderlichen Ansteuersignale, beispielsweise Gate-Ansteuersignale, in unmittelbarer Nähe zu den aktiven Elementen erzeugt und an diese ausgegeben werden, so dass die oben erwähnten Probleme bei der Übertragung über eine sichere galvanische Trennung vermieden werden. Die Schnittstellenschaltung bewirkt die galvanische Trennung zwischen der Primärseite und der Sekundärseite und ermöglicht eine serielle Datenkommunikation von einer zentralen Einheit mit der Ansteuerlogik und die Bereitstellung einer Hilfsenergieversorgung für die Treiberschaltung auf der Sekundärseite. Die Ansteuerlogik kann durch die übertragenen Daten eingestellt bzw. programmiert werden, um die erwünschte Erzeugung der Gate-Ansteuersignale zu bewirken. Ferner kann vorgesehen sein, dass die Logikschaltung vorbestimmte Messungen durchführt bzw. Steuerungs- und/oder Regelungsaufgaben übernimmt. Basierend auf dem Primärsignal kann zusätzlich zu den Hilfsenergieversorgungen für die Treiberschaltungen auch eine Hilfsenergieversorgung zum Betreiben der Logikeinheit und/oder einer Messschaltung bereitgestellt werden.

Der erfindungsgemäße Ansatz ist vorteilhaft, da hierdurch eine minimale Koppelkapazität erreicht wird, da über den einzelnen Transformator in der Schnittstellenschaltung sowohl die Datenkommunikation als auch die Energieversorgung ermöglicht wird, so dass zusätzliche, eine erhöhte Kopplung bewirkende Transformatoren zum Einspeisen der Hilfsenergieversorgungen vermieden werden. Es ist somit nur noch ein Übertrager bzw. Transformator für z.B. das komplette IPM erforderlich, der beispielsweise auch als Vollbrücke oder in einer anderen, bekannten Schaltungskonfiguration ausgestaltet sein kann.

Erfindungsgemäß wird durch die Ausgestaltung der Schaltung das Auftreten von Jitter und von Verzögerungen und die damit einhergehende Problematik, die sich bei einer direkten Übertragung der Gate-Signale über eine sichere Isolationsbarriere (galvanische Trennung) ergibt, vermieden bzw. reduziert. Ferner erlaubt die erfindungsgemäße Schaltung die Verwendung beliebiger Isolationsspannungen sowie eine sichere galvanische Trennung durch den Übertrager bzw. Transformator. Erfindungsgemäß wird ferner eine störsichere Übertragung aufgrund der galvanischen Trennung sowie eine minimale Koppelkapazität und eine niedrige Impedanz sichergestellt. Durch Implementierung geeigneter Korrektur- und Prüfmechanismen ist auch eine fehlertolerante Übertragung ohne Weiteres implementierbar.

Gemäß Ausführungsbeispielen ist eine Kommunikation über einen Bus vorgesehen, der eine Zwei-Draht-Verbindung bereitstellt, so dass nur zwei verpolsichere Drähte für die gesamte Steuerung der Einheit, inklusive der Programmierung, erforderlich sind. Gemäß Ausführungsbeispielen ist eine einfachste Ansteuerung vorgesehen, die z.B. auf dem UART-Standard (UART = Universal Asynchronous Receiver Transmitter) basiert, über den typischerweise mehrere IPMs (z.B. 8 IPMs) ansteuerbar sind.

Ein weiterer Vorteil der erfindungsgemäßen Vorgehensweise besteht darin, dass der Aufwand im Hinblick auf die bereitzustellenden Verbinder und die erforderliche Verkabelung reduziert bzw. minimiert wird, ebenso wie das Bauvolumen und die damit einhergehenden Kosten.

Wiederum ein weiterer Vorteil der vorliegenden Erfindung besteht darin, dass aufgrund der sicheren galvanischen Trennung durch den Transformator die Ansteuerung der Leistungsschalter auch mittels sogenannter Pegelanpassungsschaltungen (Levelshifter) erfolgen kann, bzw. über galvanisch trennende Schaltungen mit niedrigeren Isolationsanforderungen (z.B. nur Betriebsisolation).

Ausführungsbeispiele der vorliegenden Anmeldung werden nachfolgend unter Bezugnahme auf die beiliegenden Zeichnungen näher erläutert. Es zeigen:
- Fig. 1: eine schematische Darstellung einer Schaltung gemäß einem Ausführungsbeispiel der Erfindung;
- Fig. 2: eine Schaltung gemäß einem Ausführungsbeispiel der vorliegenden Erfindung, bei dem die leistungselektronische Einheit einen bidirektionalen Hoch-Tiefsetzsteller umfasst;
- Fig. 3: eine Schaltung gemäß einem Ausführungsbeispiel der vorliegenden Erfindung mit zwei aktiven Elementen und zwei Logikeinheiten;
- Fig. 4: ein System gemäß einem Ausführungsbeispiel mit einer zentralen Steuereinheit, einem Bussystem und zwei seriell verschalteten Schaltungen aus Fig. 3; und
- Fig. 5: ein Ausführungsbeispiel ähnlich zu dem in Fig. 4 mit zwei parallel verschalteten Schaltungen aus Fig. 3.

In der nachfolgenden Beschreibung der Ausführungsbeispiele der vorliegenden Erfindung werden in den Figuren gezeigte gleiche oder gleichwirkende Elemente mit den gleichen Bezugszeichen versehen.

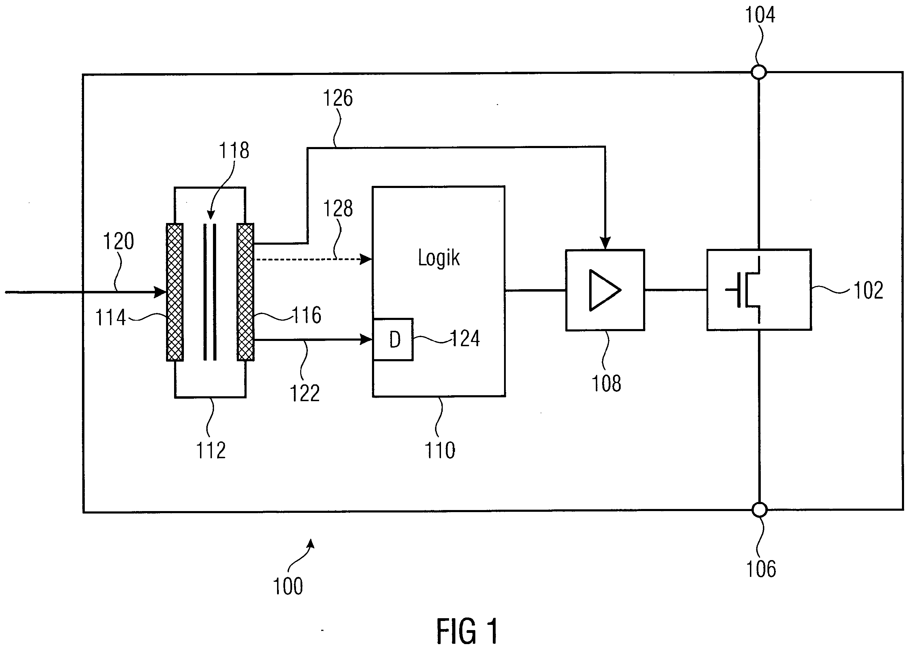

Fig. 1 zeigt eine schematische Darstellung einer Schaltung 100 gemäß einem Ausführungsbeispiel der Erfindung. Die Schaltung 100 umfasst ein aktives Element 102, beispielsweise einen leistungselektronischen Schalter, z.B. IGBT, FET oder einen Bipolartransistor. Alternativ können auch eine Mehrzahl von Bauelementen einschließlich eines oder mehrerer aktiver Bauelemente vorgesehen sein, beispielsweise eine Verschaltung einer Mehrzahl von Transistoren oder eine Verschaltung eines oder mehrerer Transistoren mit weiteren, nicht angesteuerten Elementen, beispielsweise Dioden oder passiven Elemente, wie Widerständen, induktiven Bauelementen oder Kondensatoren, wobei gemäß Ausführungsbeispielen auch diese Elemente über Steuersignale einstellbar sein können.

Das aktive Element 102 ist zwischen einen ersten Leistungsanschluss 104 der Schaltung und einen zweiten Leistungsanschluss 106 der Schaltung geschaltet, um auf ein am ersten Leistungsanschluss 104 anliegendes Leistungssignal einzuwirken und am zweiten Leistungsanschluss 106 ein Leistungssignal auszugeben. Die Schaltung 100 umfasst ferner eine Treiber- oder Ansteuerschaltung 108, die wirksam mit dem aktiven Element 102 verbunden ist, um ein Steuersignal an das aktive Element 102 auszugeben, beispielsweise ein Gate-Ansteuersignal im Falle eines IGBT bzw. FET, oder ein Steuersignal, um ein anderes, aktives bzw. einstellbares Element anzusteuern. Eine Logikschaltung 110 ist mit der Treiberschaltung 108 verbunden, um ein Aktivierungssignal bzw. Steuersignal zum Aktivieren der Treiberschaltung 108 zum Ausgeben eines Ansteuersignals an das aktive Element 102 bereitzustellen.

Die Schaltung 100 umfasst ferner eine Schnittstellenschaltung 112, die einen primären Anschluss 114 sowie einen sekundären Anschluss 116 umfasst. Der primäre Anschluss 114 und der sekundäre Anschluss 116 der Schnittstellenschaltung 112 sind galvanisch getrennt, beispielsweise durch Anordnung eines Übertragers bzw. Transformators 118, der in Fig. 1 schematisch gezeigt ist. Der primäre Anschluss 114 ist wirksam mit der Primärseite des Transformators 118 verbunden, und der sekundäre Anschluss 116 ist wirksam mit der Sekundärseite des Transformators 118 über eine Gleichrichterschaltung zum Bereitstellen der Hilfsenergieversorgung verbunden. Die Schnittstellenschaltung 112 ist vorgesehen, um an ihrem primären Anschluss 114 ein Primärsignal 120 zu empfangen, welches Daten enthält, welche eine Einstellung oder Programmierung der Ansteuerlogik 110 entsprechend erwünschten Funktionalitäten ermöglicht.

Gemäß Ausführungsbeispielen kann die Ansteuerlogik 110 unter Verwendung der durch das Primärsignal 120 übertragenen Daten programmiert werden, um eine Ansteuerung oder Regelung des aktiven Elements 102 über die Treiberschaltung 108 entsprechend einer erwünschten Funktionalität bereitzustellen.

Gemäß Ausführungsbeispielen ist vorgesehen, dass das Primärsignal ein gleichanteilfreies Rechtecksignal mit im Wesentlichen konstanter Frequenz ist, welches beispielsweise in Form eines Manchester-codierten Signals vorliegt.

Mittels des Primärsignals kann gemäß Ausführungsbeispielen ein serieller Bitstrom übertragen werden, der die zur Programmierung der Logik 110 erforderlichen Daten darstellt. Das Primärsignal 120 wird mittels des Übertragers 118 an den sekundären Anschluss 116 der Schnittstellenschaltung 112 übertragen, und von dort der Ansteuerschaltung 110 bereitgestellt, wie dies durch den Pfeil 122 angedeutet ist.

Enthält das Primärsignal die Daten in codierter Form, z.B. in Form des Manchester-codierten, seriellen Bitstroms, so kann bei solchen Ausführungsbeispielen eine Decodiererschaltung 124 vorgesehen sein, die den Bitstrom decodiert, um die Daten zur Einstellung/Programmierung der Ansteuerlogik 110 zu erhalten. Bei dem in Fig. 1 gezeigten Ausführungsbeispiel ist der Decodierer 124 als Teil der Ansteuerlogik 116 dargestellt, jedoch kann bei anderen Ausführungsbeispielen vorgesehen sein, den Decodierer als Teil der Schnittstellenschaltung vorzusehen, so dass die Schnittstellenschaltung 112 bereits den decodierten Datenstrom ausgibt. Alternativ kann eine Decodiererschaltung zwischen der Schnittstellenschaltung 112 und der Ansteuerlogik 110 vorgesehen sein.

Gemäß der vorliegenden Erfindung ist die Schnittstellenschaltung 112 ferner ausgestaltet, um an deren sekundären Anschluss 116 neben dem Datensignal, welches an die Logik 110 übergeben wird, ein Hilfsenergiesignal 126 zu erzeugen, welches für die Ansteuerung der Treiberschaltung 108 erforderlich ist. Gemäß Ausführungsbeispielen kann ferner vorgesehen sein, ein weiteres Hilfsenergiesignal 128, wie es durch den gestrichelten Pfeil verdeutlicht ist, bereitzustellen, welches an die Ansteuerlogik 110 angelegt wird, um deren Hilfsenergieversorgung zu bewirken. Der Sekundäranschluss 116 der Schnittstellenschaltung 112 kann mehrere Sekundärwicklungen umfassen, um unterschiedliche Hilfsenergieversorgungen über eine oder mehrere Gleichrichterschaltungen bereitzustellen, beispielsweise die Hilfsenergiesignale 126 und 128, die anhand der Fig. 1 dargelegt wurden.

Gemäß Ausführungsbeispielen ist vorgesehen, dass Primärsignal über eine Zwei-Draht-Verbindung an die Schnittstellenschaltung 112 bereitzustellen. Diese Vorgehensweise ist bei der Verwendung eines Transformators vorteilhaft, da dies ermöglicht, die zwei Drähte der Zwei-Drahtverbindung mit den zwei Anschlüssen auf der Primärseite des Transformators 118 zu verbinden, also mit dem ersten Anschluss der Primärwicklung und dem zweiten Anschluss der Primärwicklung. Auf der Sekundärseite der Schnittstellenschaltung 112 wird eine Hilfsenergieversorgung für die sekundärseitigen Elemente der Schaltung, beispielsweise die Logikschaltung und die Treiberschaltung, bereitgestellt. Gleichzeitig wird eine beispielsweise serielle Datenkommunikation mit der Ansteuerlogik 110 ermöglicht, die eine Generierung der Ansteuersignale für die Treiberschaltung 108 ermöglicht. Der serielle Bitstrom, der am Anschluss 114 empfangen wird und über den Transformator 118 an den sekundären Anschluss 116 weitergeleitet wird, dient somit zur Energieversorgung und zur Datenkommunikation. Für die Ansteuerung eines vollständigen bidirektionalen DC/DC-Wandlers kann beispielsweise eine Kommunikation mit 500 kBit/s vorgesehen sein. Das Datenübertragungsverfahren kann gemäß Ausführungsbeispielen so gewählt sein, dass es auch als Trigger-Signal zur Synchronisation, z.B. zur Realisierung eines phasenversetzten Betriebs mehrerer leistungselektronischer Einheiten, auf der Sekundärseite empfangen werden kann.

Gemäß Ausführungsbeispielen kann die Logikeinheit 110 einen Mikroprozessor, einen digitalen Signalprozessor, ein FPGA oder eine ASIC umfassen. Die Logikeinheit 110 kann neben der Generierung der Ansteuersignale für den Treiber 108 weitere Aufgaben übernehmen, beispielsweise weitere Steuerungs- und Regelungsaufgaben, z.B. eine Stromerfassung an Elementen innerhalb des aktiven Elements 102, beispielsweise an einer Spule, eine Hochspannungs-Messung, eine Niederspannungs-Messung, eine Temperaturmessung, eine vorhersehende digitale Steuerung und/oder Regelung für verschiedene Betriebsmodi (z.B. CCM, DCM, u.a.), oder eine Synchronisation.

Erfindungsgemäß wird somit eine Schaltung geschaffen, die die im Stand der Technik auftretenden Probleme bei der sicheren galvanisch getrennten Ansteuerung eines aktiven Elements einer Leistungselektronikschaltung vermeidet bei gleichzeitiger Reduzierung des Aufwands im Hinblick auf die erforderlichen Verbindungen und bei gleichzeitiger Reduzierung der Koppelkapazität. Erfindungsgemäß wird dies, wie oben erwähnt, dadurch erreicht, dass sowohl das Signal zur Ansteuerung der Logikschaltung 110, zum Beispiel zu deren Programmierung, sowie das Hilfsenergiesignal für die verschiedenen Komponenten der Schaltung 100 aus dem empfangenen Primärsignal 120 erzeugt wird und das eigentliche, das aktive Leistungsbauelement steuernde Signal (z.B. Gate-Ansteuersignal) auf der, der Leistungselektronik, zugewandten Seite (Sekundärseite) erzeugt wird und nicht wie beim Stand der Technik auf der, der übergeordneten Steuereinheit zugewandten Seite (Primärseite). Hierdurch ist nur noch eine Schnittstelle für den Empfang der Daten und der Hilfsenergie erforderlich, wodurch sich der Umfang der erforderlichen Verbindungen der Schaltung 100 nach außen reduziert. Ferner ist nur noch ein Transformator 118 bzw. ein Element zur sicheren galvanischen Trennung erforderlich, so dass die Koppelkapazität reduziert wird und eine noch zuverlässigere und sicherere galvanische Trennung erreicht wird. Es sei darauf hingewiesen, dass die galvanische Trennung über die Schnittstelle dahingehend sicherer ist, dass eine ausreichende Isolation (z.B. ein bis mehrere kV) vorliegt, da primärseitig ein Anwender sein kann, der zu schützen ist. Die galvanische Trennung ist dabei sicherer als eine galvanische Betriebsisolation zwischen der Logikschaltung 100 und den leistungselektronischen Komponenten, deren Isolationsanforderung geringer sein kann und oft lediglich ausreichend sein muss, um z.B. die Logikeinheit zu schützen.

Nachfolgend werden Beispiele für die Realisierung einer galvanisch isolierenden Schaltung, wie sie schematisch anhand der Fig. 1 gezeigt wurde, näher erläutert.

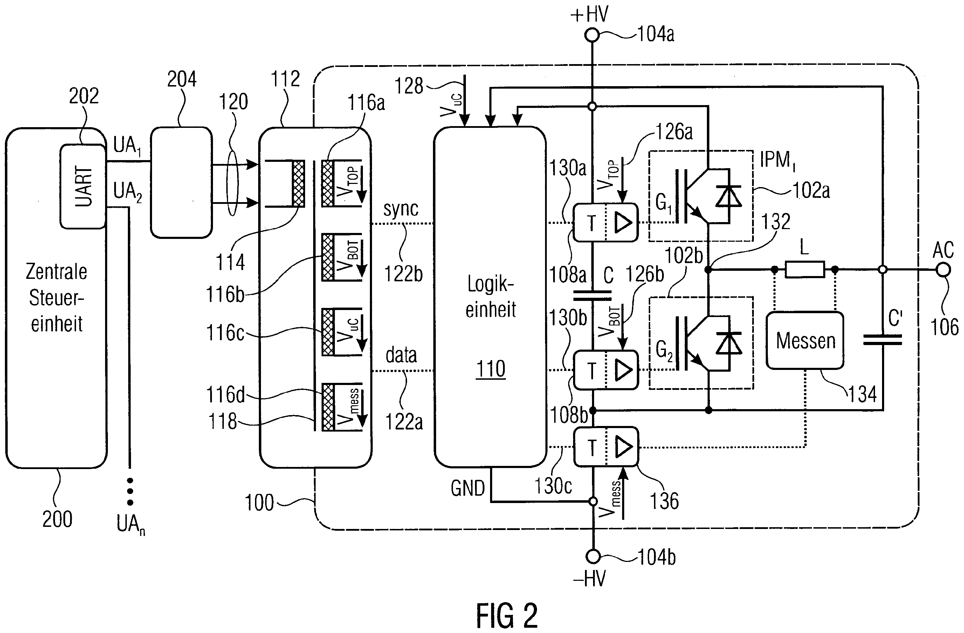

Die Fig. 2 zeigt eine Realisierung einer Schaltung gemäß einem Ausführungsbeispiel der vorliegenden Erfindung, bei dem die leistungselektronische Einheit bzw. das aktive Element 102, wie es anhand der Fig. 1 beschrieben wurde, einen bidirektionalen Hoch-Tiefsetzsteller realisiert. In Fig. 2 ist die Schaltung 100 dargestellt, die ein erstes aktives Element 102a und ein zweites aktives Element 102b umfasst. Die aktiven Elemente 102a und 102b umfassen jeweils einen IGBT, dessen Emitter-Kollektor-Strecke durch eine Diode, die in Sperrrichtung gepolt ist, überbrückt ist. Jeder aktiven Schaltung 102a, 102b ist eine entsprechende Gate-Treiberschaltung 108a, 108b zugeordnet, die wirksam mit der Ansteuerlogik 110 verbunden sind, um entsprechende Gate-Ansteuersignale an die Treiberschaltungen 108a, 108b auszugeben, wie dies durch die gestrichelten Verbindungen 130a, 130b angedeutet ist. Die Schnittstellenschaltung 112 umfasst den primären Anschluss 114 sowie mehrere sekundäre Anschlüsse 116a bis 116d. Der primäre Anschluss 114 ist durch die Primärwicklung des Transformators 118 gebildet, und die sekundären Anschlüsse 116a bis 116d sind über entsprechende Sekundärwicklungen des Transformators 118 und daran angeschlossenen Gleichrichterschaltungen realisiert. Wie durch die gestrichelte Linie 122a und die gestrichelte Linie 122b schematisch dargestellt ist, wird durch die Schnittstellenschaltung 112 bei dem in Fig. 2 gezeigten Ausführungsbeispiel zum einen das Datensignal 122a und zum anderen ein Synchronisationssignal 122b an die Ansteuereinheit 110 übertragen. Bei anderen Ausführungsbeispielen kann nur ein Datensignal vorgesehen sein, das zusätzlich die für die Synchronisation erforderliche Information enthält. Das Datensignal wird, anders als die Hilfsenergie, direkt aus dem sekundärseitigen Anschluss abgeleitet. Die erste Sekundärwicklung 116a der Schnittstellenschaltung 112 stellt das Hilfsenergiesignal 126a (Vₜₒₚ) für die Treiberschaltung 108a bereit, und die zweite Sekundärwicklung 116b stellt das Hilfsenergiesignal 126b (V_{bot}) für die zweite Treiberschaltung 108b bereit. Die dritte Sekundärwicklung 116c erzeugt das Energieversorgungssignal 126 (V_{uC}) für die Ansteuerlogik 110.

Bei dem in Fig. 2 dargestellten Ausführungsbeispiel umfassen die Treiberschaltungen 108a und 108b galvanische Trennelemente T für eine galvanische Betriebsisolation oder einen Levelshifter, um die aktiven Elemente 102a und 102b ansteuern zu können. Der in Fig. 2 gezeigte bidirektionale Hoch-Tiefsetzsteller umfasst einen ersten Gleichspannungsanschluss 104a (+HV) sowie einen zweiten Gleichspannungsanschluss 104b (-HV) zum Empfangen der positiven bzw. negativen Hochspannungspotenziale. Am zweiten Leistungsanschluss 106 befindet sich der Wechselabgang AC. Zwischen die Anschlüsse 104a und 104b ist der Speicherkondensator C geschaltet. Das erste aktive Element 102a ist zwischen den ersten Anschluss 104a und einen Zwischenknoten 132 geschaltet, und das zweite aktive Element 102b ist zwischen den Zwischenknoten 132 und den zweiten Anschluss 104b geschaltet. Der zweite Anschluss 104b ist über einen weiteren Kondensator C' mit dem Ausgangsanschluss 106 verbunden. Die Gates G₁ und G₂ sind mit den Treiberschaltungen 108a bis 108b und über diese mit der Ansteuerlogik 110 verbunden, wobei darauf hingewiesen wird, dass zwischen den Treiberschaltungen 108a und 108b und den Anschlüssen 104a und 104b keine Verbindung existiert. Zwischen den Zwischenknoten 132 und dem zweiten Leistungsanschluss 106 ist die Spule L geschaltet, wobei über die Schaltung 134 eine Spulenstrommessung bewirkt werden kann. Die Schaltung 134 und die Trennschaltung 136 werden mit Hilfsenergie (Vₘₑₛₛ) versorgt, die durch die vierte Sekundärwicklung 116d der Schnittstellenschaltung bereitgestellt wird. Die Spulenstrommessung wird durch ein Signal 130c der Ansteuerlogik 110 mitgeteilt, wobei die Schaltung 132, wie auch die Treiberschaltungen 108a, 108b eine galvanische Trennung T aufweisen kann.

Fig. 2 zeigt ferner eine zentrale Steuereinheit 200, zum Beispiel einen Mikroprozessor, der die Steuer- bzw. Datensignale für die Logikeinheit 110 erzeugt, wobei die Steuereinheit 200 z.B. eine UART-Einheit 202 aufweist, um die Datensignale entsprechend dem UART-Standard an einer oder mehreren Ausgangsleitungen UA₁ bis UAₙ bereitzustellen, beispielsweise für n unterschiedliche Schaltungen. In Fig. 2 ist lediglich eine Schaltung 100 gezeigt, für die das Datensignal UA₁ durch die zentrale Steuereinheit 200 erzeugt wird. Dieses Signal wird einer Treibereinheit 204 bereitgestellt, die am Ausgang das Primärsignal 120 zur Übertragung über die Zwei-Draht- Schnittstelle 112 bereitstellt.

Bei dem in Fig. 2 dargestellten Ausführungsbeispiel dient die Logikeinheit 110 nicht nur dazu, die Ansteuersignale zum Schalten der Gate-Anschlüsse der aktiven Elemente 102a und 102b bereitzustellen, sondern sie dient auch dazu, beispielsweise den Strom durch die Spule L zu regeln. Ferner kann für eine Spannungsregelung der Zwischenkreisspannung oder der Ausgangsspannung eine Hochspannungs- oder Niederspannungs-Messung durchgeführt werden. Zu diesem Zweck ist die Logikeinheit 110, wie in Fig. 2 dargestellt ist, zum einen mit dem ersten Anschluss 104a der Schaltung und zum anderen mit dem zweiten Anschluss 104b verbunden. Ferner ist die Logikeinheit 110, wie durch den Pfeil dargestellt ist, mit dem Ausgang 106 verbunden, um die Spannung am AC-Abgang zu erfassen.

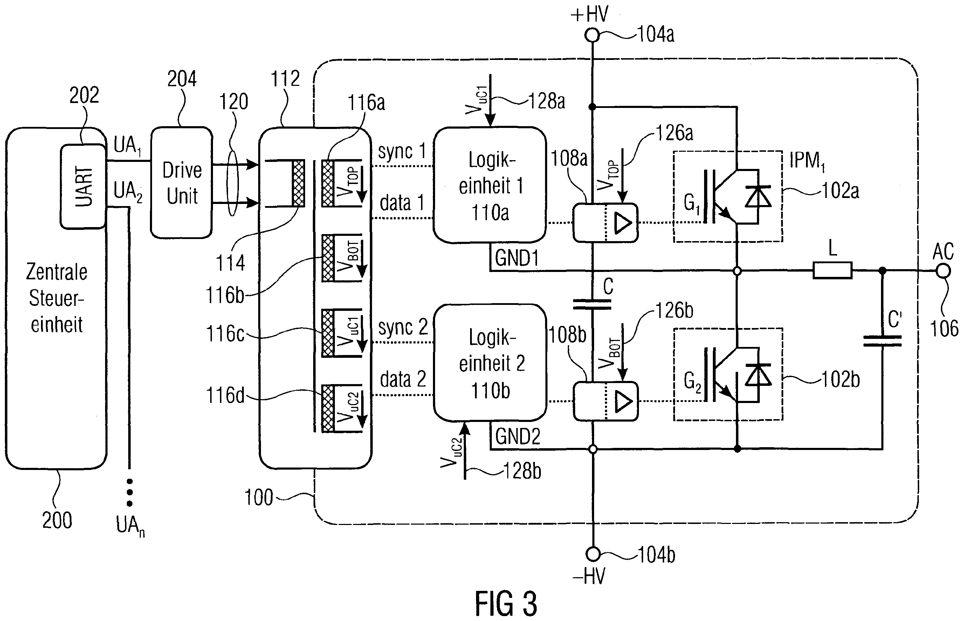

Bei dem anhand der Fig. 2 dargestellten Ausführungsbeispiel ist eine Logikeinheit 110 vorgesehen, die die Ansteuersignale für die zwei aktiven Elemente 102a und 102b erzeugt. An dieser Stelle sei jedoch darauf hingewiesen, dass die vorliegende Erfindung nicht auf eine solche Ausgestaltung beschränkt ist. Vielmehr kann vorgesehen sein, eine Ansteuereinheit für nur ein aktives Element oder für mehrere der aktiven Elemente einer Schaltung vorzusehen, wobei nachfolgend anhand der Fig. 3 ein Beispiel beschrieben wird, bei dem eine Schaltung mit zwei aktiven Elementen zwei Logikeinheiten, eine für jedes aktive Element, aufweist.

In Fig. 3 wird eine Schaltung ähnlich der Schaltung in Fig. 2 dargestellt, jedoch ohne die Spulenstrommessschaltung 132. Ferner dienen die dort gezeigten Ansteuerlogikschaltungen lediglich zur Erzeugung der Ansteuersignale, nicht jedoch zur Erfassung von Messsignalen. Elemente, die in Fig. 3 gezeigt sind, die jedoch bereits anhand der Fig. 2 beschrieben wurden, sind mit den gleichen Bezugszeichen versehen und werden nicht nochmals erläutert. Wie in Fig. 3 zu erkennen ist, umfasst die Schaltung 100 eine erste Ansteuerlogik 110a und eine zweite Ansteuerlogik 110b, die jeweils das durch die Sekundärwicklungen 116c und 116d bereitgestellten Energieversorgungssignale 128a, 128b empfangen sowie die entsprechenden Daten und/oder Synchronisationssignale 130a, 130b. Die Ansteuerlogikschaltungen 110a und 110b können entsprechende Adressen aufweisen, über die eine Adressierung der Ansteuerlogikschaltungen möglich ist. Bei dem in Fig. 3 gezeigten Ausführungsbeispiel ist die erste Ansteuerlogik 110a mit dem Knoten 132 verbunden, und die zweite Ansteuerlogik ist mit dem zweiten Anschluss 104b verbunden.

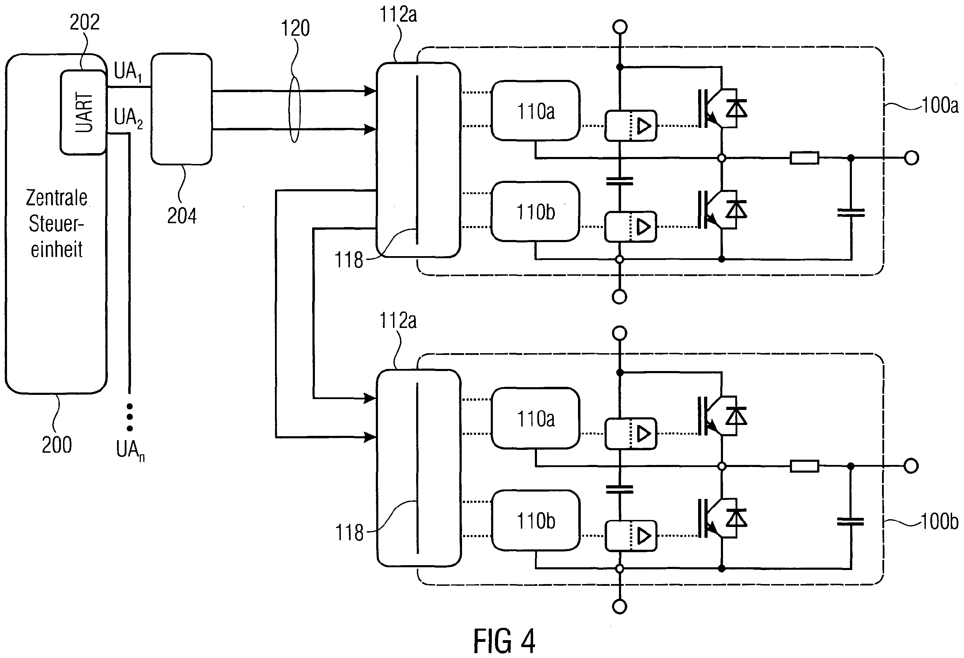

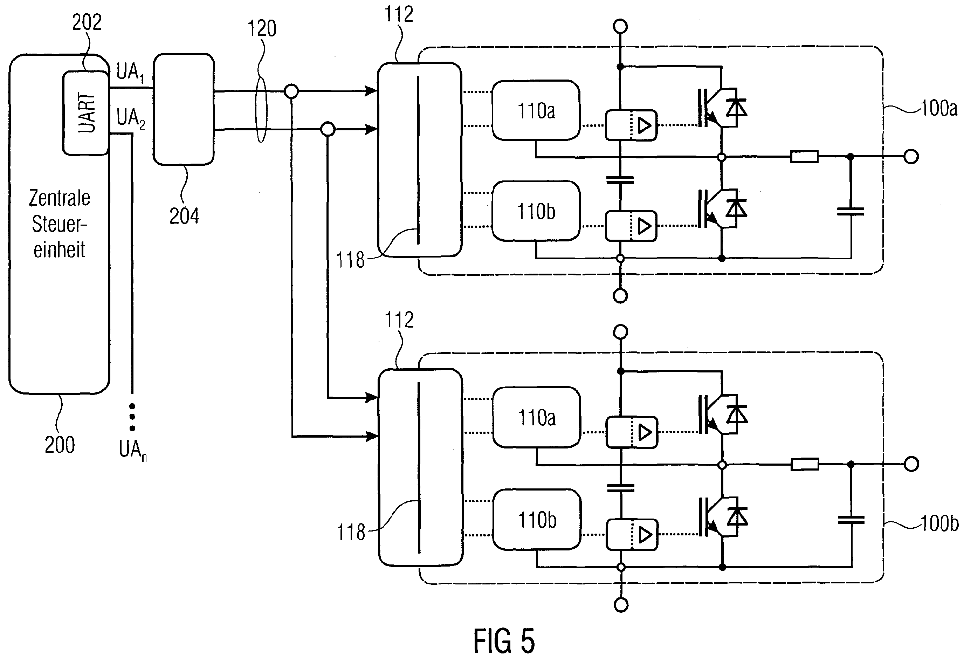

Wie oben anhand der Fig. 2 erläutert wurde, können mehrere Schaltungen 100 über die zentrale Steuereinheit 200 angesteuert werden, wie durch die Steuersignale UA₁ bis UAₙ angedeutet ist. Anstelle der anhand der Figuren 2 und 3 beschriebenen Verbindungen nur einer Schaltung mit dem Zwei-Draht-Verbindungsbus kann gemäß anderen Ausführungsbeispielen auch ein Bussystem vorgesehen sein, bei dem mehrere Schaltungen seriell bzw. parallel an ihrer Primärseite verschaltet sind, wie dies anhand der Figuren 4 und 5 nachfolgend kurz erläutert wird.

Fig. 4 zeigt ein Ausführungsbeispiel mit einem Bussystem, bei dem zwei Schaltungen 100a und 100b, die der Schaltung 100 aus Fig. 3 entsprechen, seriell miteinander verschaltet sind. Wie zu erkennen ist, empfängt die erste Schaltung 100a auf die oben beschriebene Art und Weise von der zentralen Steuereinheit 200 das Primärsignal, welches von der Primärseite der ersten Schaltung 100a an die Primärseite der Schaltung 100b weitergegeben wird, d.h. die Primärwicklungen der zwei Schnittstellenschaltungen 112 sind in Serie geschaltet.

Fig. 5 zeigt ein Ausführungsbeispiel ähnlich zu dem in Fig. 4, wobei die zwei Schaltungen 100a und 100b aber parallel geschaltet sind, indem der Zwei-Draht-Verbindungsbus eine Verbindung sowohl zu der Primärseite der ersten Schaltung 100a als auch eine Verbindung zu der Primärseite der zweiten Schaltung 100b aufweist, d.h. die Primärwicklungen der zwei Schnittstellenschaltungen 112 sind parallel geschaltet.

Gemäß weiteren Ausführungsbeispielen kann eine bidirektionale Kommunikation zwischen der Ansteuerlogik und der zentralen Steuereinheit vorgesehen sein, indem beispielsweise für vorbestimmte Zeitdauern eine Energieübertragung von der zentralen Steuereinheit 200 an die Sekundärseite unterbrochen wird, und stattdessen eine Kommunikation von der Ansteuerlogik 100, die dann für eine entsprechende Kommunikation ausgelegt ist, in Richtung der zentralen Einheit 200 bewirkt wird. Hierbei ist ein Energiespeicher auf der Sekundärseite erforderlich, der die Versorgung der Sekundärseite mit Energie (z.B. für die Ansteuerlogik 100) während dieser Zeitdauer übernimmt. Alternativ kann auch vorgesehen sein, an der Sekundärseite der Schnittstellenschaltung eine vorbestimmte Belastung bereitzustellen, die dann an der zentralen Steuereinheit 200 als Übertragung eines vorbestimmten Datenwortes erkannt wird.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Schaltung, mit
einem aktiven Element (102, 102a, 102b);
einer Treiberschaltung (108, 108a, 108b) für das aktive Element (102, 102a, 102b);
einer Ansteuerlogik (110, 110a, 110b) zum Bereitstellen eines Ansteuersignals für die Treiberschaltung (108, 108a, 108b); und
einer Schnittstellenschaltung (112) mit einem primären Anschluss (114) zum Empfang eines Primärsignals (120), dass zur Energieversorgung und zur Datenkommunikation dient, und einem sekundären Anschluss (116, 116a-116d), der galvanisch von dem primären Anschluss (114) getrennt ist,
wobei die Schnittstellenschaltung (112) ausgebildet ist, um das an dem primären Anschluss (114) empfangene Primärsignal (120) über den sekundären Anschluss (116, 116a-116d) der Ansteuerlogik (110, 110a, 110b) bereitzustellen, um das Primärsignal (120) mit einen Signalverlauf zu übertragen, der eine Energieübertragung über die Schnittstellenschaltung (112) mit der Galvanischen Trennung zulässt, und um basierend auf dem an dem primären Anschluss (114) empfangenen Primärsignal (120) ein Hilfsenergiesignal (126, 126a, 126b) für die Treiberschaltung (108, 108a, 108b) an dem sekundären Anschluss (116, 116a-116d) bereitzustellen, und
wobei die Ansteuerlogik (110, 110a, 110b) derart ausgebildet ist, dass sie mittels vom Primärsignal (120) umgefassten Daten programmiert werden kann.

2. Schaltung gemäß Anspruch 1, bei der das Primärsignal (120) ein gleichanteilfreies Rechtecksignal mit im Wesentlichen konstanter Frequenz umfasst.

3. Schaltung gemäß Anspruch 1 oder 2, bei der das Primärsignal (120) einen seriellen Bitstrom umfasst.

4. Schaltung gemäß einem der Ansprüche 1 bis 3, mit:
einem Decodierer (124), der ausgebildet ist, um das Primärsignal (120) zu decodieren, um Daten zur Programmierung der Ansteuerlogik (110, 110a, 110b) zu erhalten.

5. Schaltung gemäß einem der Ansprüche 1 bis 4, bei der die Schnittstellenschaltung (112) einen Transformator (118) und eine dem Transformator nachgeschaltete Gleichrichterschaltung umfasst, wobei an der Primärseite des Transformators das Primärsignal (120) anliegt, und an dessen Sekundärseite das Datensignal für die Ansteuerlogik (110, 110a, 110b) gewonnen wird, und wobei das Hilfsenergiesignal (126, 126a, 126b) für die Treiberschaltung (108, 108a, 108b) durch die Gleichrichterschaltung bereitgestellt wird.

6. Schaltung gemäß einem der Ansprüche 1 bis 5, bei der die Schnittstellenschaltung (112) ausgebildet ist, um basierend auf dem Primärsignal (120) ein weiteres Hilfsenergiesignal (128, 128a, 128b) für die Ansteuerlogik (110, 110a, 110b) an dem sekundären Anschluss (116, 116a-116d) bereitzustellen.

7. Schaltung gemäß einem der Ansprüche 1 bis 6, bei dem das aktive Element (102, 102a, 102b) und die Ansteuerlogik (110, 110a, 110b) galvanisch getrennt sind und/oder über eine entsprechende Pegelanpassungsschaltung verbunden sind.

8. Schaltung gemäß einem der Ansprüche 1 bis 7, mit einem ersten Leistungsanschluss (104) und einem zweiten Leistungsanschluss (106), wobei das aktive Element (102, 102a, 102b) zwischen den ersten Leistungsanschluss (104) und den zweiten Leistungsanschluss (106) geschaltet ist.

9. Schaltung gemäß einem der Ansprüche 1 bis 8, mit:
einer Messschaltung (134), die mit der Ansteuerlogik (110, 110a, 110b) zum Bereitstellen eines Messsignals an dieselbe verbunden ist,
wobei die Schnittstellenschaltung (112) ausgebildet ist, um basierend auf dem empfangenen Primärsignal (120) ein Hilfsenergiesignal für die Messschaltung (134) an dem sekundären Anschluss (116, 116a-116d) mittels Gleichrichterschaltung bereitzustellen.

10. Schaltung gemäß einem der Ansprüche 1 bis 9, mit:
zumindest einem weiteren aktiven Element (102, 102a, 102b), dem eine weitere Treiberschaltung (108, 108a, 108b) zugeordnet ist,
wobei die Schnittstellenschaltung (112) ausgebildet ist, um basierend auf dem Primärsignal (120) ein Hilfsenergiesignal (126, 126a, 126b) für die weitere Treiberschaltung (108, 108a, 108b) mittels Gleichrichterschaltung bereitzustellen.

11. Schaltung gemäß einem der Ansprüche 1 bis 10, bei der das aktive Element (102, 102a, 102b) einen oder mehrere leistungselektronischer Schalter, z.B. IGBTs, FETs oder Bipolartransistoren, umfasst, deren Steueranschlüsse mit einer oder mehreren der Treiberschaltungen (108, 108a, 108b) verbunden sind.

12. Schaltung gemäß einem der Ansprüche 1 bis 11, bei der die Ansteuerlogik (110, 110a, 110b) wirksam ist, um ansprechend auf das Primärsignal (120) eine vorbestimmte Ansteuerung der Treiberschaltung (108, 108a, 108b) für das aktive Element (102, 102a, 102b) zu bewirken und/oder vorbestimmte Messungen bzw. Steuerungen und/oder Regelungen durchzuführen.

13. Schaltung gemäß einem der Ansprüche 1 bis 12, bei dem die Schnittstellenschaltung (112) ferner ausgebildet ist, um eine Ausgabe eines Signal auf der Primärseite zu bewirken.

14. Schaltung gemäß einem der Ansprüche 1 bis 13, bei der das Primärsignal (120) Korrektur- und/oder Prüfinformationen und/oder Verschlüsselungsinformationen für eine fehlertolerante und/oder gesicherte Übertragung umfasst.

15. System, mit:
einer zentralen Steuereinheit (200); und
einer Schaltung (100, 100a) gemäß einem der Ansprüche 1 bis 14.

## Claims

1. A circuit, comprising
an active element (102, 102a, 102b);
a drive circuit (108, 108a, 108b) for the active element (102, 102a, 102b);
a control logic (110, 110a, 110b) for providing a control signal for the drive circuit (108, 108a, 108b); and
an interface circuit (112) having a primary terminal (114) for receiving a primary signal (120) that serves for energy supply and data communication and a secondary terminal (116, 116a-116d) that is galvanically isolated from the primary terminal (114),
wherein the interface circuit (112) is implemented to provide the primary signal (120) received at the primary terminal (114) to the control logic (110, 110a, 110b) via the secondary terminal (116, 116a-116d) to transmit the primary signal (120) with a waveform allowing energy transmission via the interface circuit (112) with the galvanic isolation, and to provide, based on the primary signal (120) received at the primary terminal (114), an auxiliary energy signal (126, 126a, 126b) for the drive circuit (108, 108a, 108b) at the secondary terminal (116, 116a-116d), and
wherein the control logic (110, 110a, 110b) is configured such that the same can be programmed by means of data comprised by the primary signal (120)

2. Circuit according to claim 1, wherein the primary signal (120) includes a square wave signal free from steady components with essentially constant frequency.

3. Circuit according to claim 1 or 2, wherein the primary signal (120) includes a serial bitstream.

4. Circuit according to one of claims 1 to 3, comprising:
a decoder (124) that is implemented to decode the primary signal (120) for acquiring data for programming the control logic (110, 110a, 110b).

5. Circuit according to one of claims 1 to 4, wherein the interface circuit (112) includes a transformer (118) and a rectifier circuit downstream of the transformer, wherein the primary signal (120) is applied to the primary side of the transformer, and the data signal for the control logic (110, 110a, 110b) is obtained at its secondary side, and wherein the auxiliary energy signal (126, 126a, 126b) for the drive circuit (108, 108a, 108b) is provided by the rectifier circuit.

6. Circuit according to one of claims 1 to 5, wherein the interface circuit (112) is implemented to provide, based on the primary signal (120), a further auxiliary energy signal (128, 128a, 128b) for the control logic (110, 110a, 110b) at the secondary terminal (116, 116a-116d).

7. Circuit according to one of claims 1 to 6, wherein the active element (102, 102a, 102b) and the control logic (110, 110a, 110b) are galvanically isolated and/or connected via a respective level shifting circuit.

8. Circuit according to one of claims 1 to 7 comprising a first power terminal (104) and a second power terminal (106), wherein the active element (102, 102a, 102b) is connected between the first power terminal (104) and the second power terminal (106).

9. Circuit according to one of claims 1 to 8, comprising:
a measurement circuit (134) connected to the control logic (110, 110a, 110b) for providing a measurement signal to the same,
wherein the interface circuit (112) is implemented to provide, based on the received primary signal (120), an auxiliary energy signal for the measurement circuit (134) at the secondary terminal (116, 116a-116d) by means of a rectifier circuit.

10. Circuit according to one of claims 1 to 9, comprising:
at least one further active element (102, 102a, 102b) having a further drive circuit (108, 108a, 108b) allocated thereto,
wherein the interface circuit (112) is implemented to provide, based on the primary signal (120), an auxiliary energy signal (126, 126a, 126b) for the further drive circuit (108, 108a, 108b) by means of a rectifier circuit.

11. Circuit according to one of claims 1 to 10, wherein the active element (102 102a, 102b) includes one or several power electronic switches, such as IGBTs, FETs or bipolar transistors, whose control terminals are connected to one or several of the drive circuits (108, 108a, 108b).

12. Circuit according to one of claims 1 to 11, wherein the control logic (110, 110a, 110b) is effective to cause, in response to the primary signal (120), a predetermined control of the drive circuit (108, 108a, 108b) for the active element (102, 102a, 102b) and/or to perform predetermined measurements or controls and/or regulations.

13. Circuit according to one of claims 1 to 12, wherein the interface circuit (112) is further implemented to effect an output of a signal on the primary side.

14. Circuit according to one of claims 1 to 13, wherein the primary signal (120) includes correction and/or check information and/or encryption information for fault-tolerant and/or secure transmission.

15. A system, comprising
a central control unit (200); and
a circuit (100, 100a) according to one of claims 1 to 14.

## Revendications

1. Circuit, avec
un élément actif (102 102a, 102b);
un circuit de commande (108, 108a, 108b) de l'élément actif (102, 102a, 102b);
une logique de commande (110, 110a, 110b) destinée à mettre à disposition un signal de commande pour le circuit de commande (108, 108a, 108b); et
un circuit d'interface (112) avec une borne primaire (114) pour recevoir un signal primaire (120) qui sert à l'alimentation en énergie et à la communication de données, et une borne secondaire (116, 116a à 116d) qui est séparée galvaniquement de la borne primaire (114),
dans lequel ledit circuit d'interface (112) est conçu pour mettre à disposition de la logique de commande (110, 110a, 110b) le signal primaire (120) reçu à la borne primaire (114), par l'intermédiaire de la borne secondaire (116, 116a à 116d), pour transmettre le signal primaire (120) avec une évolution de signal qui permet un transfert d'énergie par l'intermédiaire du circuit d'interface (112) avec la séparation galvanique, et pour mettre à disposition, à la borne secondaire (116, 116a à 116d), sur base du signal primaire (120) reçu à la borne primaire (114), un signal d'énergie secondaire (126, 126a, 126b) pour le circuit de commande (108, 108a, 108b), et
dans lequel la logique de commande (110, 110a, 110b) est conçue de sorte qu'elle puisse être programmée au moyen de données comprises dans le signal primaire (120).

2. Circuit selon la revendication 1, dans lequel le signal primaire (120) comporte un signal rectangulaire exempt de composante directe à fréquence sensiblement constante.

3. Circuit selon la revendication 1 ou 2, dans lequel le signal primaire (120) comporte un flux de bits série.

4. Circuit selon l'une des revendications 1 à 3, avec:
un décodeur (124) qui est conçu pour décoder le signal primaire (120) pour obtenir des données pour la programmation de la logique de commande (110, 110a, 110b).

5. Circuit selon l'une des revendications 1 à 4, dans lequel le circuit d'interface (112) comporte un transformateur (118) et un circuit redresseur connecté en aval du transformateur, dans lequel est présent, du côté primaire du transformateur, le signal primaire (120), et de son côté secondaire est obtenu le signal de données pour la logique de commande (110, 110a, 110b), et dans lequel le signal d'énergie auxiliaire (126, 126a, 126b) pour le circuit de commande (108, 108a, 108b) est mis à disposition par le circuit redresseur.

6. Circuit selon l'une des revendications 1 à 5, dans lequel le circuit d'interface (112) est conçu pour mettre à disposition, à la borne secondaire (116, 116a à 116d), sur base du signal primaire (120), un autre signal d'énergie auxiliaire (128, 128a, 128b) pour la logique de commande (110, 110a, 110b).

7. Circuit selon l'une des revendications 1 à 6, dans lequel l'élément actif (102, 102a, 102b) et la logique de commande (110, 110a, 110b) sont séparés galvaniquement et/ou sont connectés par l'intermédiaire d'un circuit d'adaptation de niveau correspondant.

8. Circuit selon l'une des revendications 1 à 7, avec une première borne de puissance (104) et une deuxième borne de puissance (106), dans lequel l'élément actif (102, 102a, 102b) est connecté entre la première borne de puissance (104) et la deuxième borne de puissance (106).

9. Circuit selon l'une des revendications 1 à 8, avec:
un circuit de mesure (134) qui est connecté à la logique de commande (110, 110a, 110b) pour mettre un signal de mesure à disposition de cette dernière,
dans lequel le circuit d'interface (112) est conçu pour mettre à disposition à la borne secondaire (116, 116a à 116d), au moyen du circuit redresseur, sur base du signal primaire (120) reçu, un signal d'énergie auxiliaire pour le circuit de mesure (134).

10. Circuit selon l'une des revendications 1 à 9, avec:
au moins un autre élément actif (102, 102a, 102b) auquel est associé un autre circuit de commande (108, 108a, 108b),
dans lequel le circuit d'interface (112) est conçu pour mettre à disposition, au moyen du circuit redresseur, sur base du signal primaire (120), un signal d'énergie auxiliaire (126, 126a, 126b) pour l'autre circuit de commande (108, 108a, 108b).

11. Circuit selon l'une des revendications 1 à 10, dans lequel l'élément actif (102, 102a, 102b) comporte un ou plusieurs interrupteurs électroniques de puissance, par exemple des IGBT, des FET, ou des transistors bipolaires dont les bornes de commande sont connectées à un ou plusieurs des circuits de commande (108, 108a, 108b).

12. Circuit selon l'une des revendications 1 à 11, dans lequel la logique de commande (110, 110a, 110b) est opérationnelle pour provoquer, en réponse au signal primaire (120), une activation prédéterminée du circuit de commande (108, 108a, 108b) pour l'élément actif (102, 102a, 102b) et/ou pour réaliser des mesures ou commandes et/ou régulations prédéterminées.

13. Circuit selon l'une des revendications 1 à 12, dans lequel le circuit d'interface (112) est par ailleurs conçu pour provoquer une sortie d'un signal du côté primaire.

14. Circuit selon l'une des revendications 1 à 13, dans lequel le signal primaire (120) comporte des informations de correction et/ou de test et/ou des informations de cryptage pour une transmission avec tolérance d'erreurs et/ou sécurisée.

15. Système, avec:
une unité de commande centrale (200); et
un circuit (100, 100a) selon l'une des revendications 1 à 14.
